(19) Europäisches Patentamt
European Patent Office
Office européen des brevets

(11) **EP 4 625 064 A1**

(12) **DEMANDE DE BREVET EUROPEEN**

(43) Date de publication:
**01.10.2025 Bulletin 2025/40**

(21) Numéro de dépôt: **24167072.8**

(22) Date de dépôt: **27.03.2024**

(51) Classification Internationale des Brevets (IPC):
**G04B 17/06** (2006.01)  **G04D 3/00** (2006.01)
**B81C 1/00** (2006.01)

(52) Classification Coopérative des Brevets (CPC):
**G04B 17/066; G04D 3/0089**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(71) Demandeur: **Richemont International S.A.
1752 Villars-sur-Glâne (CH)**

(72) Inventeurs:
• **CHABART, Mickaël
2014 Fleurier (CH)**
• **MONTINARO, Enrica
3012 Bern (CH)**

(74) Mandataire: **Novagraaf International SA
Chemin de l'Echo 3
1213 Onex, Geneva (CH)**

(54) **PROCÉDÉ DE FABRICATION DE COMPOSANTS HORLOGERS EN SILICIUM**

(57) Un procédé de fabrication d'une pluralité de composants horlogers (90) en silicium dans une plaquette est décrit. Le procédé comprend les étapes suivantes : (a) se doter d'une plaquette (10, 110) ayant un côté inférieur (10A, 110A) et un côté supérieur (10B, 110B), la plaquette (10, 110) comprenant une couche simple en silicium (30, 130) sans couche de support, la couche simple (30, 130) ayant une épaisseur ($e_{30}$, $e_{130}$) plus importante qu'une épaisseur maximale ($e_{90}$) des composants horlogers ; (b) former les composants horlogers (90) en gravant des motifs dans la couche en silicium (30, 30', 130, 130') depuis le côté supérieur (10B, 110B) de la plaquette (10, 110) ; et (c) soit avant soit après l'étape (b), graver la plaquette (10, 110) depuis son côté inférieur (10A, 110A) pour amincir la plaquette au moins localement en formant au moins une zone amincie (36, 38, 38', 136) dans laquelle les composants horlogers (90) ont été ou seront formés, l'au moins une zone amincie (36, 38, 38', 136) ayant une épaisseur sensiblement égale à l'épaisseur maximale ($e_{90}$) des composants horlogers.

FIG. 1q

EP 4 625 064 A1

## Description

<u>Domaine technique</u>

L'invention concerne un procédé de fabrication de composants horlogers en silicium. Un tel procédé de fabrication comprend généralement des étapes de microfabrication incluant la lithographie et la gravure d'une plaquette comprenant une couche en silicium pour former les motifs des composants horlogers ainsi que des étapes de fabrication postérieures à la gravure telles que la libération des composants et le lissage des surfaces gravées.

<u>Etat de la technique</u>

La fabrication de composants horlogers en silicium tels que, mais de façon non limitative, des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage par gravure dans une plaquette en silicium. Les procédés de réalisation de ces composants horlogers utilisent généralement des plaquettes de silicium monocristallin, mais des plaquettes en silicium polycristallin ou silicium amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde sur le composant. Quand les composants horlogers sont réalisés à partir d'une plaquette en silicium monocristallin, l'une quelconque des trois orientations cristallines <100>, <110> ou <111> peut être utilisée. Les plaquettes de silicium sont proposées sous forme de couche simple sans couche de support, par exemple des plaquettes simples de type SSP (« Single Side polished » en anglais) ou de type DSP (« Dual Side Polished » en anglais). Le document EP3495894 décrit un procédé de fabrication de composants horlogers en silicium utilisant une telle plaquette comprenant une couche simple en silicium sans couche de support. Selon ce document, la plaquette simple a une épaisseur sensiblement égale à l'épaisseur maximale des composants horlogers à fabriquer, et pour former les composants horlogers, on effectue une étape de gravure dans toute l'épaisseur de la plaquette, la totalité du matériau du composant présent dans la plaquette étant ainsi utilisée pour former les composants horlogers, sans fonction de support dans la plaquette. Après leur formation, les composants horlogers ne sont supportés structurellement que par des ponts de liaison fins qui les maintiennent attachés aux parties subsistantes de la couche simple en silicium, et il est possible d'effectuer des étapes de fabrication subséquentes sur la quasi-totalité de la surface externe des composants sans qu'il soit nécessaire d'effectuer une étape de libération des composants auparavant. Cependant, dans le procédé de fabrication du document EP3495894, l'étape de gravure est délicate car elle a lieu dans une plaquette relativement mince, et donc fragile, sans aucun support.

Selon d'autres approches, des plaquettes SOI (« silicon-on-insulator » en anglais) sont aussi souvent utilisées pour la fabrication de composants horlogers. Une plaquette SOI comprend une couche de travail en silicium (la couche « device » en anglais) dans laquelle les composants horlogers sont fabriqués, une couche de support typiquement en silicium qui sert de substrat ou de support lors de la fabrication des composants (la couche « handle » en anglais), et une couche d'oxyde de silicium enterrée qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail d'un wafer SOI, ces derniers sont normalement libérés de la couche de support et de la couche d'oxyde enterrée de la plaquette SOI en utilisant des techniques de microfabrication afin de faciliter des étapes de fabrication subséquentes. De cette manière, après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur l'ensemble de la surface externe des composants de la plaquette. Les étapes subséquentes peuvent notamment comprendre des étapes d'oxydation et de désoxydation pour le lissage des surfaces des composants. Les étapes subséquentes peuvent également comprendre des étapes d'oxydation et de désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique.

La libération des composants horlogers sur une plaquette SOI peut être réalisée par différentes méthodes. Selon une approche décrite dans le document WO2019180596, après la formation des composants, la couche de travail (ou une partie de cette couche comprenant les composants) est séparée de la couche de support. Cette séparation peut être facilitée par la gravure d'une saignée entourant les composants ainsi que des ouvertures dans la couche de travail. Par la suite, la couche d'oxyde enterrée est gravée avec de la vapeur d'acide fluorhydrique (HF) qui passe au travers des ouvertures formées dans la couche de travail, et la partie de la couche de travail définie par la saignée est séparée de la couche de support de la plaquette SOI. Une autre approche de libération est décrite dans les documents de brevet JP2017219520 et WO2019180177. Selon cette approche, après la formation des composants par gravure, on fait croître une couche d'oxyde de silicium en surface du silicium. Cette couche d'oxyde sert de protection pour les composants formés. Par la suite, on réalise une photolithographie et une gravure pour exposer le silicium de la couche de support et graver la couche de support en l'attaquant par la face opposée aux composants, ce qui supprime la couche de support en dessous des composants. Pour terminer la libération selon cette alternative, on élimine la couche enterrée du wafer SOI en dessous des composants ainsi que la couche de protection sur les composants.

Ces approches de libération des composants horlogers dans une plaquette SOI impliquent des étapes de microfabrication supplémentaires dans une salle blanche et sont par conséquent relativement longues, complexes et chères. Il serait alors souhaitable d'avoir un procédé de fabrication de composants horlogers en silicium plus simple, plus rapide et moins couteux.

Bref résumé de l'invention

Un but de la présente invention est de proposer un procédé de fabrication d'une pluralité de composants horlogers sur une plaquette simple comprenant une seule couche en silicium, qui permet d'éviter ou de pallier les inconvénients ci-dessus, ou en tout cas d'offrir un meilleur compromis entre ces inconvénients.

En particulier, ce but est au moins partiellement atteint en proposant un nouveau procédé de fabrication selon lequel les composants horlogers sont formés dans une plaquette simple plus épaisse que l'épaisseur maximale des composant horlogers, et une étape de gravure est réalisée pour amincir la plaquette depuis son côté inférieur à au moins une zone de la plaquette dans laquelle les composants horlogers ont été ou seront formés. Le procédé de fabrication des composants horlogers dans la couche en silicium a alors lieu dans une plaquette simple suffisamment épaisse et solide pour faciliter au moins une partie des étapes de microfabrication, et la libération des composants dans la plaquette est réalisée par une étape de gravure qui est simple, rapide et économique. La gravure pour amincir la plaquette peut être réalisée soit après soit avant la formation des composants horlogers.

Ainsi, selon un aspect, la présente invention concerne un procédé de fabrication d'une pluralité de composants horlogers en silicium dans une plaquette, le procédé comprenant les étapes suivantes : (a) se doter d'une plaquette ayant un côté inférieur et un côté supérieur, la plaquette comprenant une couche simple en silicium sans couche de support, la couche simple ayant une épaisseur plus importante qu'une épaisseur maximale des composants horlogers ; (b) former les composants horlogers en gravant des motifs dans la couche en silicium depuis le côté supérieur de la plaquette ; et (c) soit avant soit après l'étape (b), graver la plaquette depuis son côté inferieur pour amincir la plaquette au moins localement en formant au moins une zone amincie dans laquelle les composants horlogers ont été ou seront formés, l'au moins une zone amincie ayant une épaisseur sensiblement égale à l'épaisseur maximale des composants horlogers.

D'autres caractéristiques avantageuses et privilégiées du procédé de fabrication selon l'invention sont précisées dans la description et les sous-revendications ci-dessous.

Brève description des figures

Des exemples de mise en oeuvre de l'invention sont indiqués dans la description illustrée par les figures annexées dans lesquelles :

- Les figures 1a-1q illustrent schématiquement une série d'étapes de fabrication d'un composant horloger dans une plaquette simple selon un mode de réalisation ;

- Les figures 2 et 2A sont des vues de dessus de la plaquette simple de la figure 1;

- Les figures 3A à 3C sont des vues en sections selon la ligne III-III de la figure 3 pour trois modes de réalisations ; et

- Les figures 4a-4p illustrent schématiquement une série d'étapes de fabrication d'un composant horloger dans une plaquette simple selon un autre mode de réalisation.

Exemples de mode de réalisation de l'invention

Dans tout ce qui suit, les orientations sont définies en fonction des orientations des figures. En particulier, les termes comme « supérieur », « inférieur », « horizontal », « verticale », « gauche », « droit », « dessus », « dessous », « vers l'avant » et « vers l'arrière » s'entendent généralement par rapport au sens de représentation des figures, sauf où une indication contraire est donnée (par exemple quand une vue est invertie). Les figures sont schématiques et peuvent présenter des proportions et/ou des aspects différents de la réalité même au sein d'une même figure, mais illustrent à tout le moins le déroulement et/ou les étapes des procédés décrits.

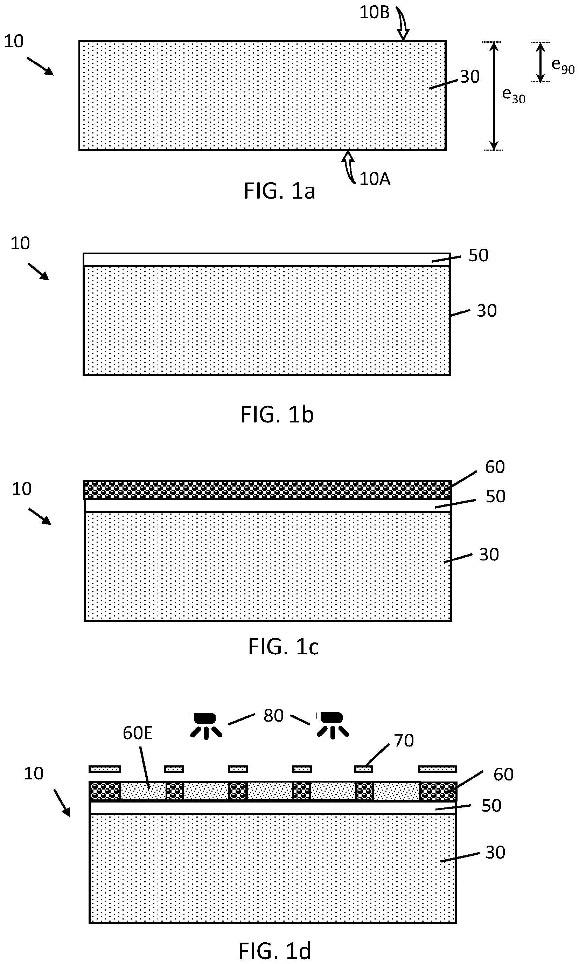

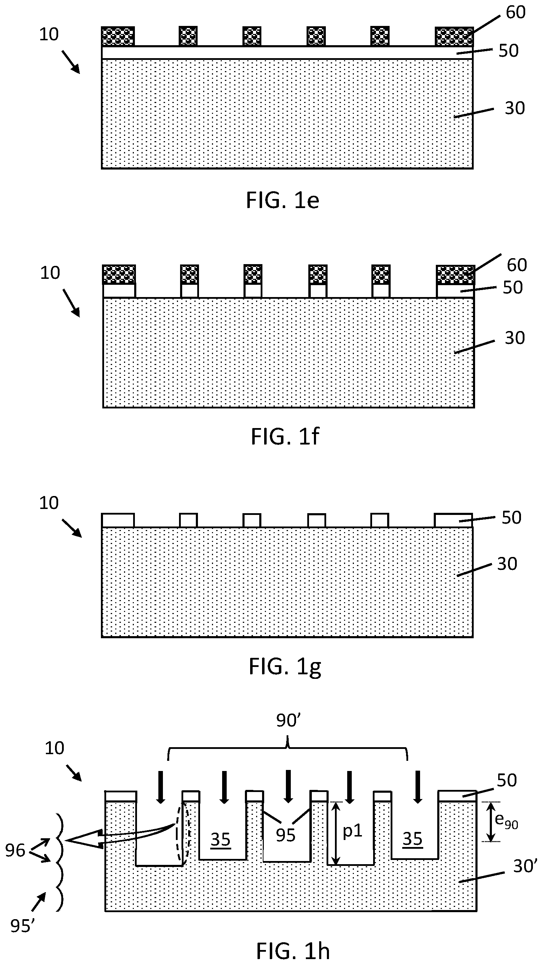

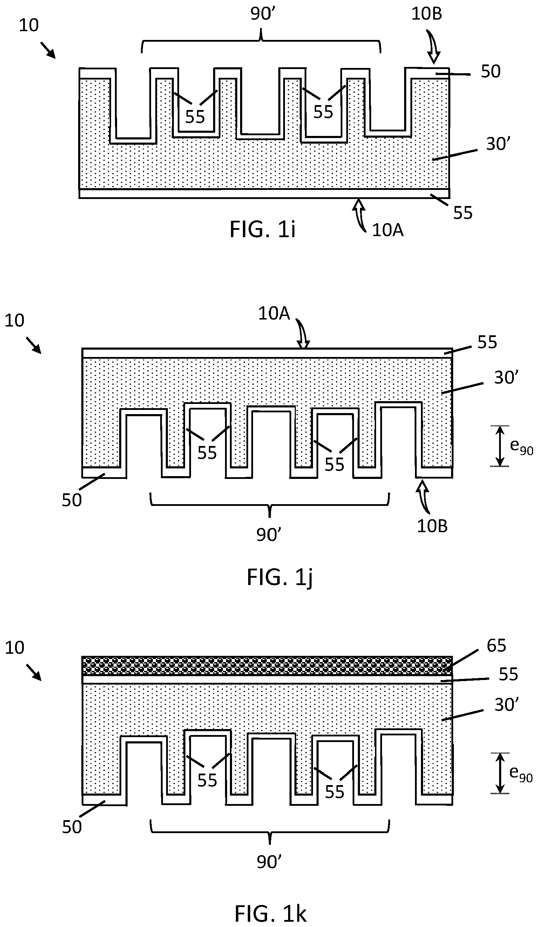

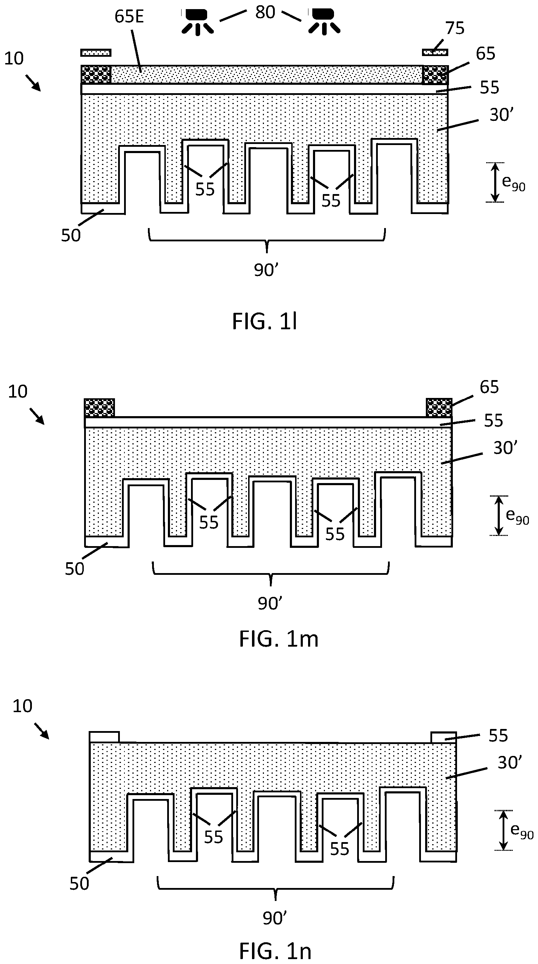

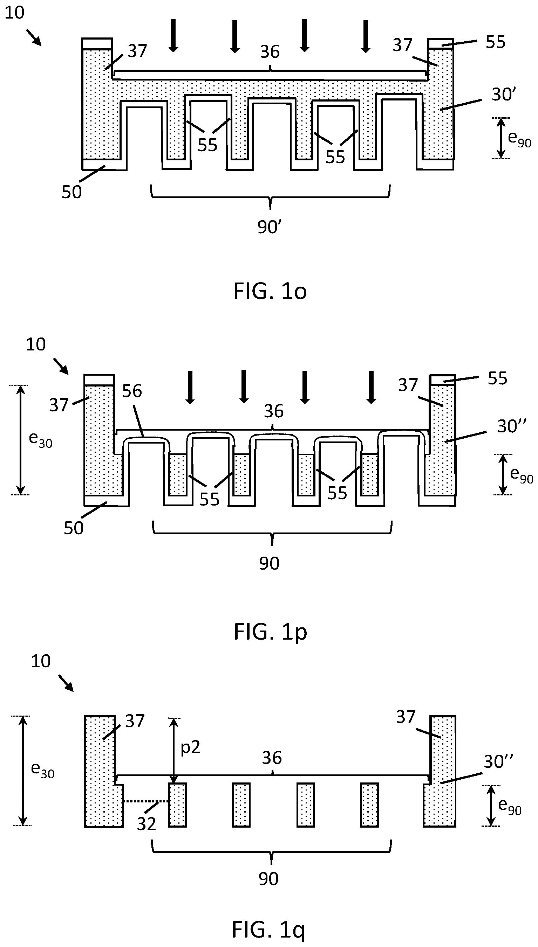

Les figures 1a-1p illustrent une série d'étapes de fabrication schématiques d'un composant horloger dans une plaquette simple 10 selon un mode de réalisation de l'invention. Bien entendu, plusieurs composants horlogers peuvent être fabriqués dans la plaquette 10 en même temps, mais les vues de la figure 1 sont isolées sur un seul composant pour des raisons de simplicité. Le procédé commence avec la plaquette simple 10 illustrée à la figure 1a, cette plaquette comprenant une couche simple 30 en silicium sans couche de support. La couche simple 30 (voire la plaquette 10) a une épaisseur initiale e30 qui est plus importante que l'épaisseur maximale e90 des composants horlogers à former. Le dessin n'est pas à l'échelle, mais à titre d'exemple, la couche simple 30 peut avoir une épaisseur initiale e30 de 150 $\mu$m - 500 $\mu$m, et de préférence de 200 $\mu$m - 300 $\mu$m. Dans un exemple, la couche simple 30 a une épaisseur e30 de 250 $\mu$m. Pour sa part, l'épaisseur maximale e90 des composants horlogers peut varier, mais dans un exemple elle est égale à 120 $\mu$m. En général, on peut avoir une tolérance d'au moins $\pm$ 5 $\mu$m autour de cette épaisseur ciblée e90, car l'épaisseur finale des composants horlogers ne constitue pas typiquement une caractéristique critique dans leur performance. La couche simple 30 peut être en silicium monocristallin avec une orientation cristalline quelconque, en silicium polycristallin, ou en silicium amorphe, et elle peut être dopée type N ou type P. L'utilisation d'un silicium fortement dopé peut être avantageuse pour la fabrication des résonateurs car, par exemple, on constate une déformation moindre de la matière dopée lors de l'oxydation thermique sous certaines conditions. La plaquette 10 comprend un côté inférieur 10A, et c'est depuis ce côté que la plaquette 10 repose normalement sur des équipements lors des étapes de microfabrication pour former les composants horlogers. La plaquette 10 comprend également un côté supérieur 10B, et c'est depuis ce côté que ces étapes de microfabrication pour former les composants horlogers sont généralement effectuées.

Lors des différentes étapes de fabrication décrites ci-dessous (incluant la lithographie et la gravure), la couche simple 30 peut être montée sur un support plan (non illustré), mais cela n'est pas indispensable puisque la couche simple 30 a quand même une épaisseur e30 qui est plus importante que l'épaisseur maximale e90 des composants horlogers à former. Cependant, si c'est utile, un tel support peut être par exemple en métal, en céramique, en verre, en quartz ou en silicium et de préférence le support est plus épais et/ou plus rigide que la couche simple 30 afin qu'il soit plus facile de le manipuler. Par ailleurs, pour au moins certaines des étapes, la couche simple peut également être liée temporairement à un tel support par des moyens adhésifs (par exemple de la colle ou un ruban adhésif appliqué à la périphérie de la couche) ou un système d'aspiration sous vide.

Dans la figure 1b, une étape de lithographie commence avec la formation d'une couche d'oxyde de silicium 50 sur la surface supérieure de la couche simple 30. Par « lithographie », on entend l'ensemble des opérations permettant de transférer une image ou un motif sur ou au-dessus de la plaquette 10 vers cette dernière. La couche d'oxyde 50 peut par exemple avoir une épaisseur comprise entre 0.4 - 6 $\mu$m, et elle peut être formée par oxydation thermique ou alternativement par un dépôt de type PVD, CVD, ou ALD. Si la couche d'oxyde 50 est formée par un procédé de dépôt directionnel tel que le CVD ou le PVD, l'oxyde se forme uniquement sur la surface supérieure de la couche simple 30, tel qu'illustré à la figure 1b. Alternativement, si la couche d'oxyde 50 est formée par oxydation thermique, on remarque que l'oxyde 50 se forme généralement en même temps sur la surface inférieure de la couche simple 30 ou encore un second dépôt directionnel de type CVD ou PVD peut être effectué sur cette surface. De manière générale, la formation de la couche d'oxyde 50 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche simple 30. Cependant, dans d'autres modes de réalisation, il est également possible de réaliser une étape de lithographie sans la couche d'oxyde, notamment en utilisant une résine photosensible plus épaisse. A la figure 1c, la couche d'oxyde 50 est recouverte d'une couche de résine 60, qui est typiquement une résine photosensible de type positif ou négatif. Cette couche de résine peut avoir une épaisseur comprise entre 0.5 - 12 $\mu$m, à titre purement illustratif. Par la suite, dans la figure 1d, la couche de résine 60 est structurée de préférence en utilisant une étape de photolithographie avec une source de lumière ultraviolette 80 ainsi que, par exemple, un masque d'exposition 70 tel qu'un photomasque. Un système de stepper et réticule peut également être utilisé pour l'étape de photolithographie. Dans l'exemple illustré, la couche 60 comprend une résine photosensible de type positif dont les parties 60E de la résine qui sont exposées à la lumière deviennent solubles dans un révélateur et les parties non exposées restent insolubles. Selon d'autres modes de réalisation, la résine peut être structurée par un faisceau laser ou d'électrons.

Dans la figure 1e, la couche de résine 60 est ouverte après avoir été développée par un révélateur, notamment un solvant qui élimine les parties exposées 60E de la résine par voie chimique. Ensuite, à la figure 1f, les parties de la couche d'oxyde 50 qui se trouvaient en dessous des parties exposées 60E de la résine sont aussi retirées de la surface de la couche simple 30, par exemple en employant une gravure plasma sélective avec les gaz CH$_4$/O$_2$. L'utilisation d'une technique de gravure directionnelle est généralement privilégiée lors de cette étape car elle est plus précise, mais alternativement une gravure à base de vapeur d'acide fluorhydrique (HF) peut aussi être utilisée.

A l'étape illustrée à la figure 1g, la partie restante de la couche de résine 60 est éliminée et ensuite, à l'étape de la figure 1h, des motifs séparés par des tranchées 35 sont gravés dans la couche simple 30 au travers de la couche 50 structurée pour former une version brute, autrement dit une ébauche, du composant horloger 90' dans une couche simple structurée 30'. Dans le mode de réalisation illustré, les motifs gravés ne s'étendent pas sur toute l'épaisseur $e_{30}$ de la couche simple structurée 30', mais les tranchées 35 formées dans cette couche ont toutes une profondeur p1 plus importante que l'épaisseur maximum $e_{90}$ des composants horlogers. Par ailleurs, la profondeur des tranchées 35 formées dans la couche simple structurée 30' peut varier légèrement entre elles (l'effet étant exagéré dans la figure 1h), puisqu'il n'y a pas de couche d'arrêt pour arrêter la gravure uniformément. Dans un mode de réalisation alternatif (non illustré), il est également possible que les motifs gravés et les tranchées 35 s'étendent sur toute l'épaisseur $e_{30}$ de la couche simple.

La gravure à l'étape de la figure 1h peut notamment être effectuée par une technique de gravure ionique réactive profonde (également connue sous l'acronyme DRIE pour « Deep Reactive Ion Etching » en anglais). La gravure DRIE permet d'usiner des trous et des tranchées profondes dans la couche simple avec un rapport largeur/hauteur important, ce qui est bien adapté pour des composants micromécaniques comme des composants horlogers. Alternativement, la structuration de la couche simple peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Une structuration par gravure humide/chimique peut notamment être plus rapide qu'une gravure ionique réactive profonde, mais la résolution dimensionnelle des structures gravées est généralement moins bonne. Si une opération de gravure humide/chimique anisotrope est employée, la couche d'oxyde 50 n'est pas nécessairement formée sur la surface supérieure de la couche simple 30 avant le dépôt de la résine 60 sur cette surface.

Il est également possible pour la partie restante de la couche de résine 60 d'être toujours présente lors de l'étape de gravure (DRIE ou autre) de la couche simple 30. Cette partie restante de la couche de résine peut être retirée après la gravure, et dans ce cas, la couche simple 30 est gravée au travers des deux couches 50, 60 structurées (ou seulement à travers la couche 60 structurée si une couche d'oxyde 50 n'est pas présente). A titre d'exemple, une résine positive peut être retirée par des solvants de type acétone ou diméthylsulfoxyde (DMSO) ou avec un plasma O2 soit avant soit après l'étape de gravure. Pour une résine négative comme le SU-8, un plasma CF4/O2 peut être employé pour son retrait.

Le procédé de fabrication continue dans ce mode de réalisation par une série d'étapes servant à amincir la plaquette 10 au moins localement à au moins une zone de la plaquette dans laquelle les composants horlogers sont formés. Dans la figure 1h, chaque composant horloger est formé dans une zone amincie différente de la plaquette. L'amincissement est effectué par une gravure depuis le côté inferieur 10A de la plaquette 10, et chaque zone d'amincie a une épaisseur sensiblement égale à l'épaisseur maximale $e90$ des composants horlogers. A la fin de ces étapes pour amincir la plaquette, les composants horlogers formés auront alors une épaisseur maximale qui est sensiblement égale à leur épaisseur maximale $e90$ et en même temps ils seront libres sur la plaquette (mais comme décrit ci-dessous maintenus toujours à la plaquette par le biais d'un pont de liaison) afin qu'une ou plusieurs étapes de fabrication subséquentes peuvent être effectuées sur sensiblement la totalité de leur surface externe.

En premier, une couche de protection est formée sur les ébauches de composants 90', notamment pour les protéger durant les étapes ultérieures du procédé. Dans un mode de réalisation privilégié, la couche de protection est une couche d'oxyde de silicium (SiO2). Comme illustré à la figure 1i, une telle couche d'oxyde de silicium 55 est formée sur l'ensemble des surfaces exposées des ébauches de composants 90' incluant leurs surfaces flancs 95. La couche d'oxyde 55 peut être formée par un dépôt de type PVD, CVD, ou ALD, mais de préférence elle est formée par oxydation thermique, et dans ce cas la couche d'oxyde 55 est formée également surtout le silicium exposé de la plaquette 10, incluant la surface inférieure de la couche simple structurée 30'. L'épaisseur de cette couche d'oxyde 55 peut varier mais de préférence elle est d'au moins 0.2 $\mu$m. Par ailleurs, la couche d'oxyde 55 rejoint la couche d'oxyde 50 déjà présente sur la surface supérieure des ébauches des composants horlogers 90', et cette dernière couche peut aussi devenir plus épaisse si le dépôt de cette étape est effectué par oxydation thermique. Selon une variante, la couche d'oxyde 50 peut être éliminée après l'étape de gravure à la figure 1h, et dans ce cas la couche d'oxyde 55 se forme également sur la surface supérieure des ébauches 90' lors de l'étape de la figure 1i.

Dans un mode de réalisation non illustré, pour augmenter la protection des ébauches des composants horlogers, la surface supérieure de la couche simple structurée 30' et donc les ébauches des composants horlogers 90' formées dans cette couche (qui sont déjà recouverts par les couches d'oxydes 50, 55) sont également recouvertes, du moins en partie, d'une deuxième couche de protection, par exemple en résine ou en parylène. Le dépôt d'une telle deuxième couche de protection (par exemple en résine) peut être effectué par un revêtement obtenu par pulvérisation (en anglais « spray coating ») mais il peut également être réalisé par un trempage (en anglais « dip coating »), par une enduction par centrifugation (en anglais « spin coating »), ou par un dépôt sous vide avec de la poudre. Si une résine est utilisée comme couche de protection, elle est de préférence une résine qui résiste à des agents de gravure humide du silicium tel que le KOH, par exemple une résine photosensible de type négatif. Selon une variante, on peut sauter ou éviter la formation de l'oxyde 55 à l'étape de la figure 1i, et la deuxième couche de protection peut être déposée directement sur les ébauches des composants horlogers 90' (avec ou sans la couche d'oxyde 50) après l'étape de la figure 1h.

Après la formation de la première et/ou la deuxième couche de protection, un ruban adhésif (non illustré) sensible à la lumière ultraviolette (UV) peut également être appliqué sur la surface supérieure de la plaquette 10 (voire depuis son côté supérieure 10B) après la formation des ébauches de composants 90'. Ce ruban peut servir également à protéger les composants horlogers lors des prochaines étapes, et il peut être enlevé par irradiation de lumière ultraviolette après ces étapes. Un ruban type « blue tape » qui peut être dissolu avec l'acétone est également utilisable.

A une étape suivante, illustrée à la figure 1j, la plaquette est retournée afin que son côté inferieur 10A se trouve vers le haut et que c'est depuis son côté supérieur 10B que la plaquette 10 repose sur des équipements pour les prochaines étapes de microfabrication. Si une couche d'oxyde de silicium (SiO2) 55 n'est pas déjà présente sur la surface inférieure de la couche simple structurée 30' (voire la surface du côté inferieur 10A de la plaquette), une couche d'oxyde peut également être formée sur cette surface lors de cette étape.

Le procédé de fabrication continue à l'étape de la figure 1k où la couche d'oxyde 55 sur la surface inférieure de la couche simple structurée 30' est recouverte d'une couche de résine 65, qui peut-être une résine photosensible de type positif ou négatif. Cette couche de résine 65 peut avoir une épaisseur comprise entre 0.5 - 12 μm, à titre purement illustratif. Il est également possible d'employer la couche de résine 65 sans la couche d'oxyde 55, en particulier quand une gravure humide anisotrope sera utilisée pour amincir la couche simple structurée 30' aux étapes subséquentes.

Par la suite, dans la figure 1l, la couche de résine 65 est structurée de préférence en utilisant une étape de photolithographie avec une source de lumière ultraviolette 80 ainsi que, par exemple, un masque d'exposition 75 tel qu'un photomasque. Un système de stepper et réticule peut également être utilisé pour l'étape de photolithographie. Dans l'exemple illustré, la couche 65 comprend une résine photosensible de type positif dont les parties 65E de la résine qui sont exposées à la lumière deviennent solubles dans un révélateur et les parties non exposées restent insolubles. Selon d'autres modes de réalisation, la résine peut être structurée par un faisceau laser ou d'électrons.

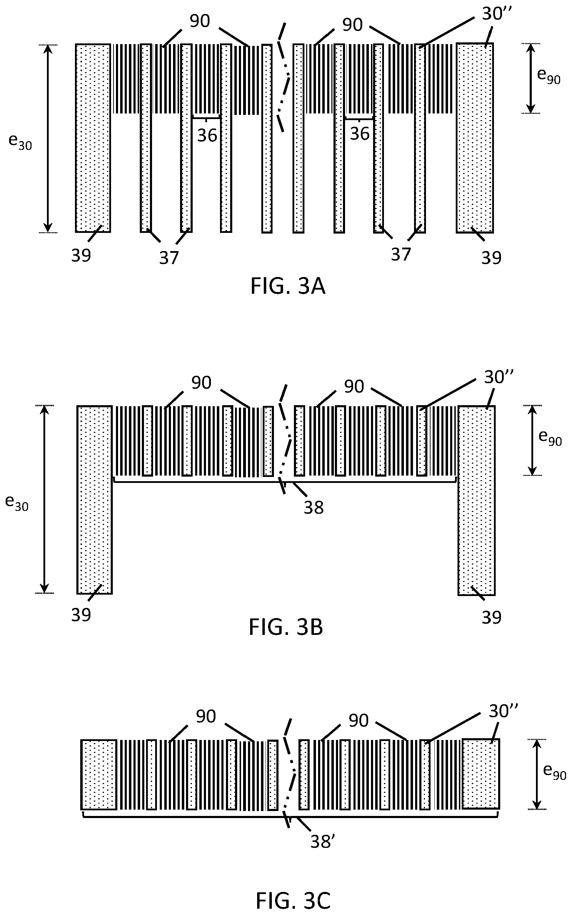

Les parties exposées 65E de la couche de résine 65 correspondent alors aux zones de la couche simple structurée 30' qui seront gravées et donc amincies lors des prochaines étapes du procédé de fabrication. Dans le mode de réalisation illustré à la figure 1l, les parties exposées 65E correspondent chacune à une zone 36 (voir les figures 1p à 1q) dans laquelle une ébauche de composants horloger 90' a été formée mais pas à des régions situées entre ces zones, voire les régions 37 entre les composants horlogers, qui ne sont pas amincies. Chaque zone 36 a de préférence une superficie plus importante que la superficie du composant horloger sur la couche simple de la plaquette. D'autres modes de réalisation sont cependant possibles, notamment des modes où soit une plus grande superficie soit toute la superficie de la couche simple structurée 30' est amincie, comme sera décrit ci-dessous en relation avec la figure 3.

Dans la figure 1m, la couche de résine 65 est ouverte après avoir été développée par un révélateur, notamment un solvant qui élimine les parties exposées 65E de la résine par voie chimique. Ensuite, à la figure 1n, les parties de la couche d'oxyde 55 qui se trouvaient en dessous des parties exposées 65E de la résine sont aussi retirées de la surface de la couche simple structurée 30', par exemple en employant une gravure plasma sélective avec les gaz CH4/O2. L'utilisation d'une technique de gravure directionnelle est généralement privilégiée lors de cette étape car elle est plus précise, mais alternativement une gravure à base de vapeur d'acide fluorhydrique (HF) peut aussi être utilisé.

A l'étape illustrée à la figure 1o, la partie restante de la couche de résine 65 est éliminée et ensuite on commence la gravure de la couche simple structurée 30' à travers les ouvertures de la couche 55 structurée pour amincir la couche simple structurée 30' dans les zones 36. La gravure à cette étape peut être réalisée par une opération de gravure humide (chimique) et de préférence par une gravure humide anisotrope, par exemple en utilisant un bain d'hydroxyde de potassium (KOH) ou d'hydroxyde de tétraméthylammonium (TMAH). Même si dans la vue de la figure 1o, les flancs gravés sont illustrés schématiquement comme étant plutôt droits et verticaux, comme la personne du métier le sait, avec une gravure humide anisotrope les flancs gravés seraient typiquement inclinés afin que la partie gravée du silicium aurait généralement une forme trapézoïdale en fonction de l'orientation cristalline du silicium de la couche simple. Alternativement, d'autres technologies de gravure peuvent être utilisées comme par exemple une gravure DRIE. Il est également possible pour la partie restante de la couche de résine 65 d'être toujours présente lors de cette étape de gravure. Cette partie restante de la couche de résine peut être retirée après la gravure, et dans ce cas, la couche simple 30 est gravée au travers des deux couches 55, 65 structurées (ou seulement à travers la couche 65 structurée si une couche d'oxyde 55 n'est pas présente). A titre d'exemple, une résine positive peut être retirée par des solvants de type acétone ou diméthylsulfoxyde (DMSO) ou avec un plasma O2 soit avant soit après l'étape de gravure. Pour une résine négative comme le SU-8, un plasma CF4/O2 peut être employé pour son retrait.

La gravure de la couche simple structurée 30' dans les zones 36 continue jusqu'au point que l'épaisseur restante de la couche simple dans ces zones est sensiblement égale à l'épaisseur maximale (e90) des composants horlogers, comme illustré à la figure 1p. Dans la couche simple structurée amincie 30" qui en résulte, la couche d'oxyde 55 de protection (et/ou toute deuxième couche de protection formée à l'étape de la figure 1i) est toujours présente sur et éventuellement entre les motifs des composants horlogers 90 comme l'est apercevable dans la figure 1p. Les parties 56 de la couche d'oxyde 55 se trouvant entre les motifs des composants horlogers 90 peuvent être abimées par la gravure précédente, et la couche d'oxyde 55 peut même briser à ces endroits dans certains cas à la fin de la gravure mais sans compromettre la protection des composants horlogers.

Si un ruban adhésif sensible à la lumière UV est utilisé, elle est enlevée par irradiation UV, et par la suite, à la figure 1q, on effectue une désoxydation pour éliminer la d'oxyde 55 autour des composants horlogers 90. Cette étape de désoxydation est de préférence réalisée par une gravure par voie humide ou en phase vapeur à base d'acide fluorhydrique (HF). Comme illustré dans la figure 1q, la profondeur p2 de la gravure dans les zones amincies de la couche simple structurée amincie 30" est sensiblement égale à la différence entre l'épaisseur initiale e30 de la couche simple 30 de la plaquette et l'épaisseur maximale e90 des composants horlogers.

La formation de la couche d'oxyde 55 par oxydation thermique à la figure 1i peut aussi faire partie d'une étape de lissage des composants horlogers 90. En fait, après l'étape de gravure de la couche simple pour former les motifs des composants horlogers 90, il est connu que les surfaces des flancs 95 de ces motifs structurés possèdent une rugosité relativement importante. Dans le cadre d'une gravure type DRIE à l'étape de la figure 1h, cette rugosité se manifeste sous la forme d'une surface 95' avec des ondulations souvent appelées « scallops » avec des pics 96 comme illustré sur la partie gauche de la figure 1h. En fait, lors d'une gravure DRIE, on alterne entre une phase de gravure du silicium et une phase de passivation ce qui résulte en la surface ondulée 95'. Après une gravure DRIE ou un autre type de gravure, la rugosité des surfaces 95 peut être réduite par une étape de lissage, ce qui renforce ces surfaces mécaniquement en limitant les amorces de rupture. Ce lissage peut notamment être effectué par une étape d'oxydation thermique (typiquement dans un four) suivie par une étape de désoxydation, constituée par exemple d'une gravure par voie humide ou en phase vapeur à base d'acide fluorhydrique (HF). De manière connue, lors de l'oxydation thermique, le silicium à la surface 95 est consommée, et cette consommation est généralement plus rapide vers les pics 96, ce qui résulte en une surface de silicium plus lisse après la désoxydation.

Comme illustré à la figure 1q, les composants horlogers 90 dans la couche simple structurée amincie 30" sont libres et ne sont supportés structurellement que par des ponts de liaison (formés lors de la gravure initiale des ébauches des composants horlogers) afin que les composants 90 restent attachés aux parties subsistantes de cette couche même après cette libération. Un tel pont est illustré schématiquement en trait à 32 dans la figure 1q, mais en réalité le pont s'étend généralement sur toute l'épaisseur du composant horloger. Il est alors possible par la suite d'effectuer des étapes de fabrication subséquentes sur la quasi-totalité de la surface externe de l'ensemble des composants horlogers 90 formées dans la couche simple structurée amincie 30".

Les étapes subséquentes peuvent par exemple comprendre un autre jeu d'étapes d'oxydation et de désoxydation pour lisser encore les surfaces des composants horlogers et/ou pour ajuster les dimensions des composants. Un tel ajustement peut notamment être employé pour corriger la raideur quand les composants sont des spiraux ou des résonateurs. Une étape d'oxydation sans désoxydation (ou sans désoxydation complète) est également possible pour former une couche externe d'oxyde de silicium permanente sur les composants. Dans le cadre d'un spiral ou d'un autre type de résonateur horloger, une telle couche d'oxyde permanente compense les variations du module d'Young de l'âme en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachés à la couche simple structurée amincie 30", comme par exemple pour assembler le composant à un axe, un tigeron, un piton ou une virole.

Comme expliqué ci-dessous, chaque étape d'oxydation thermique sert à réduire légèrement les dimensions de l'âme en silicium des composants horlogers, et pour cette raison l'épaisseur maximale final de l'âme des composants après toutes les étapes de fabrication subséquentes peut être légèrement moins importante que l'épaisseur maximale e90.

La gravure aux étapes des figures 1o et 1p pour obtenir la couche simple structurée amincie 30" peut avoir une vitesse qui varie en ajustant les paramètres de gravure, en particulier la température et/ou la concentration de l'agent de gravure dans le cadre d'une gravure humide. Par exemple, pour une gravure humide utilisant un bain de KOH, il est connu que (i) pour une température donnée la vitesse de gravure diminue quand la concentration de KOH dans le bain augmente et (ii) pour une concentration de KOH donnée, la vitesse de gravure diminue quand la température diminue. A titre d'exemple : à une température de 90°C, la vitesse de gravure du silicium monocristallin d'orientation <100> ou <110> est environ trois fois plus rapide avec une concentration de 20% KOH qu'à une concentration de 60% KOH ; et pour un bain avec une concentration de 20% KOH, la vitesse de gravure du silicium monocristallin d'orientation <100> ou <110> est plus de dix fois plus rapide à une température de 90°C qu'à une température de 40°C. Voir par exemple Seidel et al, « Anisotropic wet chemical structuring of silicon according », J. Electrochem. Soc., Vol. 137, No. 11 Nov. 1990, 3612-3632. Des phénomènes similaires ont été observées pour une gravure humide du silicium utilisant un bain de TMAH - voir par exemple Jun et al., « Silicon etching characteristics for tetramethylammonium hydroxide-based solution with additives », IET Micro & Nano Letters, Vol. 10, issue 10, Oct 2015, 487-490.

De cette manière, en variant les paramètres de la gravure, l'étape de gravure aux figures 1o et 1p peut être divisée en deux ou plusieurs phases, chacune avec une vitesse de gravure différente notamment pour ralentir la vitesse de gravure quand l'épaisseur de la couche simple dans les zones amincies 36 s'approche de l'épaisseur maximale e90 des composants horlogers ciblée.

Il est également possible d'arrêter l'étape de gravure à différents moments et d'effectuer une ou plusieurs mesures intermédiaires de l'épaisseur actuelle de la couche simple dans les zones 36 pour vérifier le taux de réduction de l'épaisseur et ajuster, si nécessaire, les paramètres de la gravure afin de bien arriver à l'épaisseur ciblée. Alternativement, si la gravure aux figures 1o et 1p est réalisée par DRIE, il est également possible de contrôler la profondeur gravée précisément en contrôlant les paramètres de la gravure tels que le nombre de pulses, l'énergie des pulses, la durée des pulses, et la pression des gaz de réaction.

Par conséquent, on peut généralement amincir les zones 36 de la couche simple avec une tolérance d'environ $\pm$ 2 $\mu$m autour de l'épaisseur ciblée e90 des composants horlogers. De toute façon, comme indiqué ci-dessus, l'épaisseur finale des composants horlogers ne constitue pas typiquement une caractéristique critique dans leur performance, et en général il a été constaté qu'une tolérance de $\pm$ 5 $\mu$m ou plus autour de la valeur de l'épaisseur ciblée e90 n'affecte pas le fonctionnement du composant horloger d'une manière importante. Par exemple, pour un spiral destiné à équiper un oscillateur balancier-spiral, le formule définissant la fréquence $f_0$ de l'oscillateur est donné par

$$f_0 = \frac{1}{2\pi}\sqrt{\frac{Eew^3}{12LJ_B}}$$

avec JB l'inertie du balancier, E le module de Young du spiral, et e, w et L respectivement l'épaisseur, la largeur et la longueur du spiral (en supposant que le spiral a une section constante et donc que les valeurs e et w ne varient pas). On observe alors que toute variation de la largeur w de la section d'une spire a considérablement plus d'influence qu'une variation de l'épaisseur e de la spire sur la fréquence.

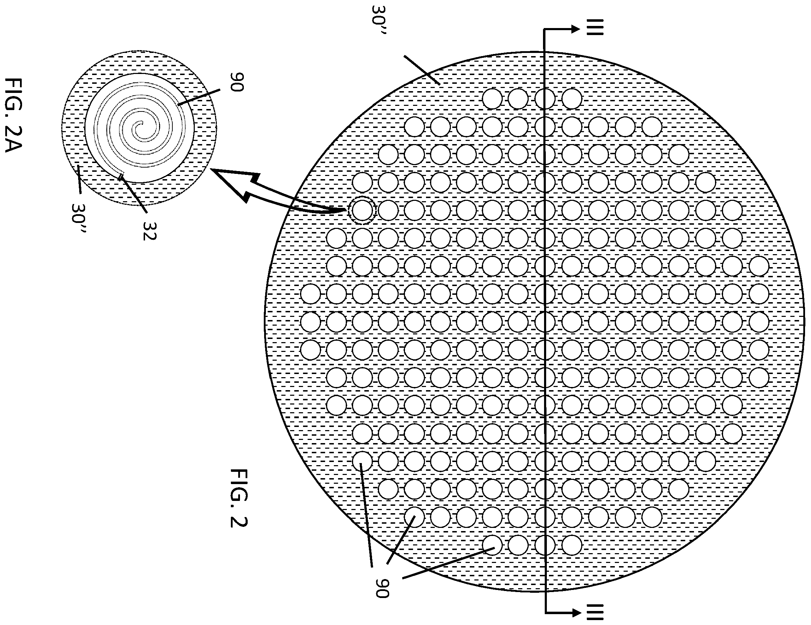

La figure 2 est une vue de dessus de la couche simple structurée amincie 30" après les étapes de fabrication des figures 1a-1q selon le mode de réalisation ci-dessus. A noter que dans la figure 2, les positions des composants horlogers 90 sur la couche sont simplement illustrés par des cercles vides afin de ne pas surcharger le dessin, mais la figure 2A donne une vue agrandie d'une de ces cercles montrant à titre d'exemple un spiral comme le composant horloger 90 et son pont de liaison 32. De préférence, les ponts de liaison 32 ont une largeur suffisante pour bien résister à un détachement des composants lors des étapes des figures 1i à 1q incluant toute étape d'irradiation UV pour enlever le ruban adhésif sensible à la lumière UV. A titre d'exemple, les ponts de liaison 32 peut avoir une largeur d'au moins 5 $\mu$m.

Les figures 3A-3C sont des vues en section selon la ligne III-III de la figure 2 montrant plusieurs composants horlogers 90 dans la couche simple structurée amincie 30" conformément à trois modes de réalisations différents. La figure 3A corresponde au mode de réalisation de la figure 1 ci-dessus où la couche simple structurée amincie 30" a été amincie dans des zones 36 (voir les figures 1p à 1q) comprenant chacun un des composants horlogers 90, mais la couche simple n'est pas amincie dans des régions 37 situées entre ces zones 36, voire entre les composants horlogers. Pour bien libérer les composants horlogers 90, chaque zone 36 a de préférence une superficie plus importante que la superficie du composant horloger lui-même sur la couche simple de la plaquette. De plus, dans le mode de réalisation de la figure 3A, la couche simple structurée amincie 30" comprend une région périphérique 39 qui n'est pas amincie et qui entoure toutes les zones amincies 36 (et donc tous les composants horlogers aussi). De préférence, cette région périphérique 39 a une largeur plus importante que les régions 37 non amincies qui se trouvent entre les composants horlogers.

Dans le mode de réalisation de la figure 3B, la couche simple structurée amincie 30" est amincie dans une seule zone 38 dans laquelle tous les composants horlogers de la plaquette sont formés. Cette zone amincie 38 est entouré par une région périphérique 39 de la plaquette 10 qui n'est pas amincie comme dans le mode de réalisation de la figure 3A. Le mode de réalisation de la figure 3B a l'avantage de ne pas exiger un alignement précis entre la formation des composants horlogers et la formation des zones amincies (telles que les zones 36) des deux côtés de la plaquette. Alternativement, toute la superficie de la couche simple peut être amincie comme dans la figure 3C où une zone unique 38' amincie s'étend sur la totalité de la couche simple structurée amincie 30". Cette approche permet de sauter ou éviter les étapes de photolithographie des figures 1j à 1n, mais résulte en une couche simple structurée amincie 30" plus fine qui risque d'être plus fragile. Pour cette raison, pour renforcer la plaquette, la couche simple structurée amincie 30" comprend de préférence au moins certaines régions 37, 39 qui ne sont pas amincies.

D'autres de modes de réalisation sont également possibles, par exemple où plusieurs des composants horlogers, mais pas tous, sont formés dans des zones amincies de la couche simple structurée amincie 30" et la couche simple structurée amincie 30" n'est pas amincie dans des régions situées entre ces zones. Par ailleurs, quand la région périphérique 39 est présente sur la couche simple structurée amincie 30", elle peut être continue ou discontinue le long de la périphérie de la plaquette.

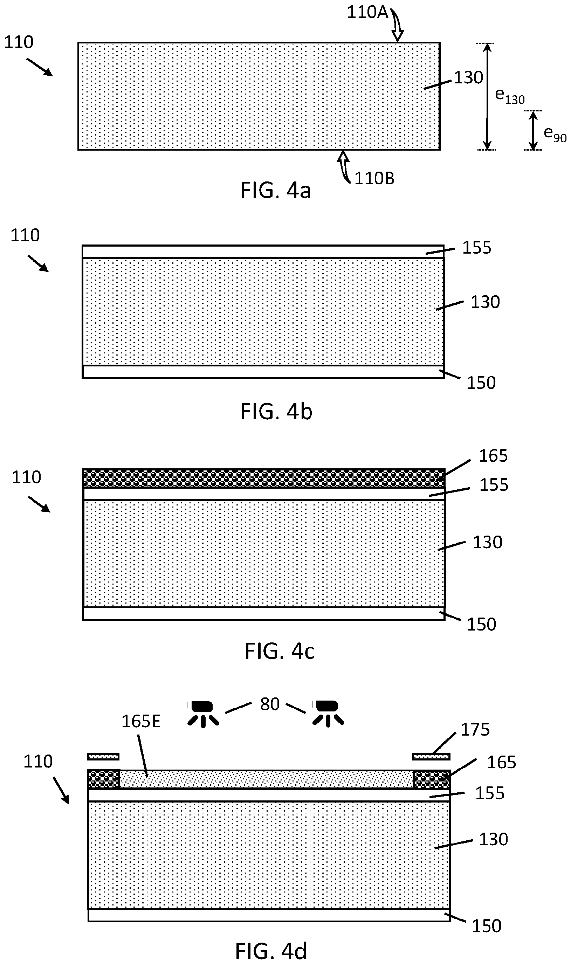

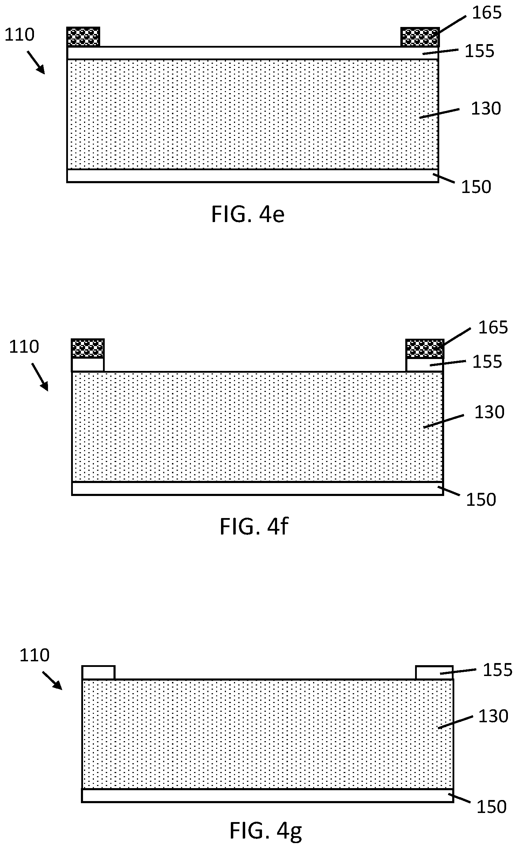

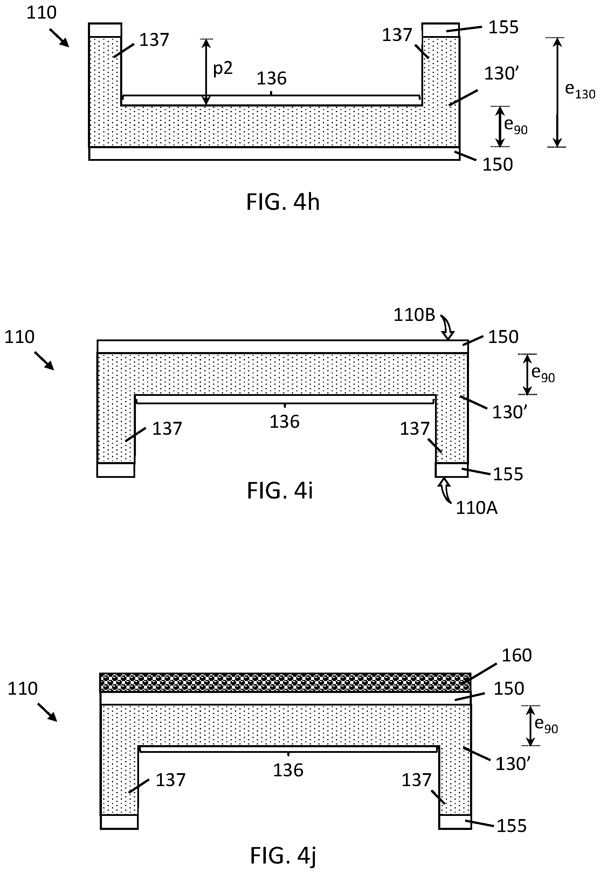

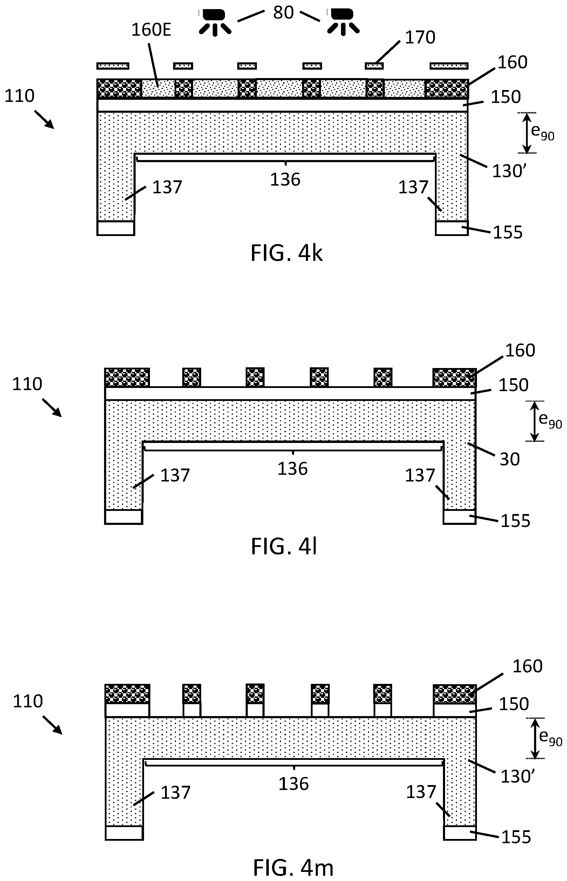

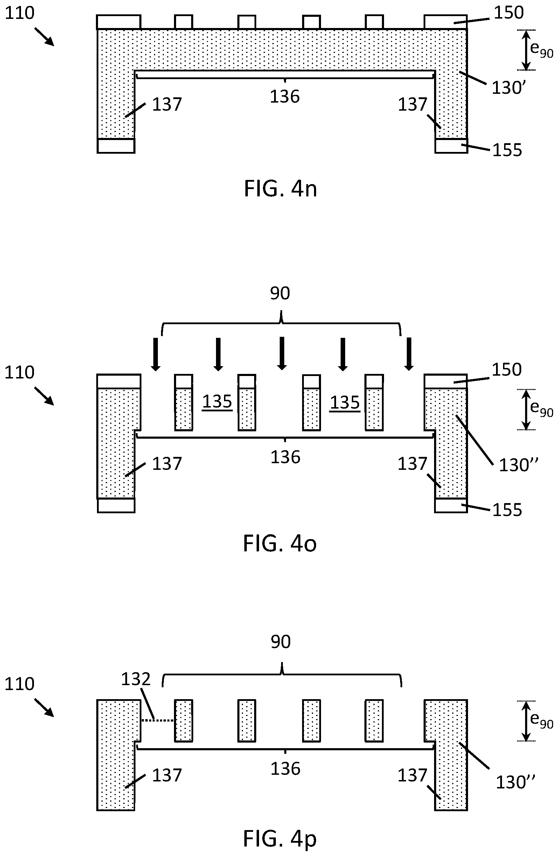

Les figures 4a-4q illustrent une série d'étapes de fabrication schématiques d'un composant horloger dans une plaquette 110 comprenant une couche simple en silicium 130 selon un autre mode de réalisation de l'invention. Les étapes de fabrication de ce mode de réalisation peuvent être essentiellement identiques à celles du premier mode de réalisation de la figure 1, mais l'ordre de ces étapes est différent. En particulier, selon le mode de réalisation de la figure 4, on grave en premier la couche simple 130 pour l'amincir au moins localement à au moins une zone de la plaquette, et par la suite les composants horlogers seront formés dans l'au moins une zone amincie.

Le procédé selon ce mode de réalisation commence avec la plaquette simple 110 illustrée à la figure 4a, qui peut être identique à la plaquette 10 de la figure 1, et qui a une épaisseur e130 qui est plus importante que l'épaisseur maximale e90 des composants horlogers. Comme pour le mode de réalisation de la figure 1, plusieurs composants horlogers peuvent être fabriqués dans la plaquette 110 en même temps, mais les vues de la figure 4 sont isolées sur un seul composant horloger pour des raisons de simplicité.

La plaquette 110 comprend un côté dit « inférieur » 110A, et c'est depuis ce côté que la plaquette 110 repose normalement sur des équipements lors des étapes de microfabrication pour former les composants horlogers. La plaquette 110 comprend également un côté dit « supérieur » 110B, et c'est depuis ce côté que ces étapes de microfabrication pour former les composants horlogers sont généralement effectuées. Cependant, dans la figure 4a, la plaquette 110 est initialement retournée avec son côté 110B vers le bas, car c'est ce côté 110B de la plaquette 110 qui repose sur des équipements lors des étapes de microfabrication initiales pour amincir la couche simple 130, au moins localement, en effectuant une gravure depuis le côté inferieur 110A de la plaquette.

A la figure 4b, une couche d'oxyde de silicium (SiO2) 155 est formée sur la surface de la couche simple 130 depuis le côté 110A de la plaquette. A cette étape, une couche de silicium (SiO2) 150 peut également être formée sur le reste de la plaquette et notamment sur sa surface depuis l'autre côté 110B de la plaquette pour protéger cette surface de la plaquette lors de la gravure d'amincissement. Les couches d'oxyde 150 et 155 peuvent également être formées en même temps lors d'une étape d'oxydation thermique. A la figure 4c, la couche d'oxyde 155 est recouverte d'une couche de résine 165 comme illustré. Il est également possible d'utiliser la couche de résine 165 sans la couche d'oxyde 155, notamment quand une gravure humide anisotrope sera employée ultérieurement pour l'amincissement de la couche simple 130. Par la suite, à la figure 4d, la couche de résine 165 est structurée dans une étape de photolithographie avec une source de lumière ultraviolette 80 et un masque d'exposition 175. Dans l'exemple illustré, la couche 165 comprend une résine photosensible de type positif dont les parties 165E de la résine qui sont exposées à la lumière deviennent solubles dans un révélateur et les parties non exposées restent insolubles.

Les parties exposées 165E de la couche de résine 165 correspondent alors aux zones de la couche simple 130 qui seront gravées et donc amincies lors des prochaines étapes du procédé de fabrication. Dans le mode de réalisation illustré, les parties exposées 165E correspondent à des zones 136 (voir la figure 4h) dans lesquelles les composants horlogers seront formés mais pas à des régions situées entre ces zones, voire les régions 137 entre ces positions futures des composants horlogers. Chaque zone amincie 136 a de préférence une superficie plus importante que la superficie du composant horloger sur la couche simple de la plaquette. On peut prévoir de former un composant horloger dans chaque zone amincie 136. On peut prévoir de former un seul composant horloger dans au moins une zone amincie 136 ou dans chaque zone amincie 136. On peut prévoir de former une pluralité de composants horlogers dans au moins une zone amincie 136 ou dans chaque zone amincie 136.

Dans la figure 4e, la couche de résine 165 est ouverte après avoir été développée par un révélateur, et, à la figure 4f les parties de la couche d'oxyde 155 qui se trouvaient en dessous des parties exposées 65E de la résine sont aussi retirées de la surface de la couche simple 130. A l'étape de la figure 4g, la partie restante de la couche de résine 165 est éliminée et ensuite on effectue une gravure de la couche simple 130 à travers les ouvertures de la couche 155 structurée pour amincir la couche simple 130 dans les zones 136 comme illustré à la figure 4h. Il est également possible pour la partie restante de la couche de résine 165 d'être toujours présente lors de cette étape de gravure. Dans le mode de réalisation illustré à la figure 4h, chaque composant horloger sera formé dans sa propre zone amincie 136.

La gravure de la couche simple 130 dans les zones 136 continue jusqu'au point que l'épaisseur restante de la couche simple dans ces zones est sensiblement égale à l'épaisseur maximale e90 des futurs composants horlogers, et une couche simple amincie 130' en résulte. Autrement dit et comme illustré à la figure 4h, la profondeur p2 de la gravure dans les zones amincies de la couche simple amincie 130' est sensiblement égale à la différence entre l'épaisseur initiale e130 de la couche simple 130 et l'épaisseur maximale e90 des composants horlogers. Comme dans le mode de réalisation de la figure 1, la gravure à cette étape peut être réalisée par une opération de gravure humide (chimique), et de préférence elle est réalisée par une gravure humide anisotrope, par exemple en utilisant un bain d'hydroxyde de potassium (KOH) ou d'hydroxyde de tétraméthylammonium (TMAH). Durant la gravure la couche 150 sert à protéger le côté 110B de la plaquette depuis lequel les composants seront formés ultérieurement. Comme décrit ci-dessus, en variant les paramètres de la gravure, on peut également ralentir la vitesse de gravure quand l'épaisseur de la couche simple 130 dans les zones amincies 136 s'approche de l'épaisseur ciblée.

A la figure 4i, les étapes pour former les composants horlogers commencent. La plaquette 110 est retournée afin que son côté supérieur 110B se trouve vers le haut et que c'est depuis son côté inférieur 110A que la plaquette 110 repose sur des équipements pour les prochaines étapes de microfabrication. La couche d'oxyde de silicium 150 déjà présente sur la surface supérieure de la couche simple amincie 130' (voire au côté supérieur 110B de la plaquette) peut aussi être utilisée pour l'étape de lithographie qui forme les composants horlogers. Alternativement, la couche de d'oxyde 150 peut être éliminée après l'amincissement de la plaquette et remplacer par une nouvelle couche d'oxyde propre formée sur cette surface supérieure de la couche simple amincie 130'. Selon une variante, une couche d'arrêt (non illustrée) est également formée depuis le côté inferieur 110A de la plaquette sur au moins la surface inferieure de la couche simple amincie 130' à la base des zones amincies 136, voire sur la surface base de ces zones. Cette couche d'arrêt peut servir à faciliter la gravure ultérieure qui formera les motifs des composants horlogers. Une telle couche d'arrêt peut être en différents matériaux tels que des métaux (par exemple l'aluminium ou le platine) ou de parylène, mais elle peut également être en oxyde de silicium.

A la figure 4j, la couche d'oxyde 150 est recouverte d'une couche de résine 160 qui comprend dans cet exemple une résine photosensible de type positif dont les parties de la résine qui sont exposées à la lumière 160E (voir la figure 4k) deviennent solubles dans un révélateur et les parties non exposées restent insolubles. Par la suite, dans la figure 4k, la couche de résine 160 est structurée en utilisant une étape de photolithographie avec une source de lumière ultraviolette 80 ainsi qu'un masque d'exposition 170 tel qu'un photomasque.

Dans la figure 4l, la couche de résine 160 est ouverte après avoir été développée par un révélateur, notamment un solvant qui élimine les parties exposées 160E de la résine par voie chimique. Ensuite, à la figure 4m, les parties de la couche d'oxyde 150 qui se trouvaient en dessous des parties exposées 160E de la résine sont aussi retirées de la surface de la couche simple amincie 130'. A l'étape illustrée à la figure 4n, la partie restante de la couche de résine 160 est éliminée et, ensuite, à l'étape de la figure 4o des motifs séparés par des tranchées 135 sont gravés (typiquement par DRIE) dans la couche simple amincie 130' au travers de la couche d'oxyde 150 structurée. Les composants horlogers 90 sont donc formés dans une couche simple amincie structurée 130" où les motifs sont gravés dans les zones 136 amincies et s'étendent sur toute l'épaisseur de la couche simple amincie dans ces zones.

Les parties restantes des couches d'oxydes 150, 155 peuvent ensuite être éliminées, et on obtient à la figure 4p une plaquette 110 comprenant les composants horlogers 90 qui sont à la bonne épaisseur et libres, à l'instar des composants horlogers de la figure 1q dans le mode de réalisation précédent. Comme expliqué ci-dessus, chaque composant horloger libre 90 est toujours supporté structurellement dans la plaquette par des ponts de liaison, illustré schématiquement en trait à 132 dans la figure 4q, ces ponts étant formés simultanément avec les composants horlogers. Par le biais de ces ponts, les composants 90 restent attachés aux parties subsistantes de la couche simple amincie structurée 130". Il est alors possible par la suite d'effectuer des étapes de fabrication subséquentes sur la quasi-totalité de la surface externe de l'ensemble des composants horlogers 90 formées dans cette couche.

Comme expliquées ci-dessus en relation avec les figures 2 et 3, à la place de former chaque composant horloger dans une zone amincie 136 dédiée relativement petite, où ces zones sont séparées par des régions 137 non amincies, il serait également possible aux étapes des figures 4a à 4h de former une zone amincie de taille plus importante dans laquelle plusieurs voir tous les composants horlogers de la plaquette sont formés comme dans la figure 3B. On peut également former une zone amincie unique qui s'étend sur la totalité de la couche simple amincie 130' comme dans la figure 3C. Cependant, comme pour le mode de réalisation de la figure 1, la couche simple amincie 130' comprend de préférence au moins certaines régions qui ne sont pas amincies pour renforcer la plaquette lors des étapes de fabrication subséquentes.

Le procédé de fabrication de composants horlogers en silicium selon l'invention a plusieurs avantages. La plaquette 10, 110, comprenant une seule couche en silicium, est plus simple et moins chère qu'une plaquette SOI multicouche, mais en même temps, pour au moins certaines des étapes de fabrication (et de préférence pour toutes les étapes), la plaquette 10, 110 a une rigidité plus importante qu'une plaquette comprenant une couche simple fine ayant la même épaisseur que l'épaisseur maximale des composants horlogers. Par ailleurs, nonobstant si l'amincissement de la couche simple de la plaquette est réalisé après ou avant la formation des composants horlogers, les étapes d'amincissement (qui servent à libérer la surface externe des composants) est relativement simple et efficace. Par rapport au mode de réalisation de la figure 1, le mode de réalisation de la figure 4 a aussi l'avantage de ne pas exiger que les composants horlogers soient protégés avant l'amincissement de la couche simple.

Les différentes étapes d'oxydation mentionnées ci-dessus peuvent être réalisées par oxydation thermique en plaçant la plaquette 10 dans un four à une température comprise entre 800°C et 1200°C et dans une atmosphère oxydante comprenant par exemple de la vapeur d'eau ou du dioxygène gazeux (O2). L'épaisseur de la couche d'oxyde formée dépend de manière connue de la durée de l'étape d'oxydation.

Une fois que les étapes de fabrication des composants horlogers 90 telle que décrites ci-dessus sont complétées, les composants horlogers peuvent être détachés individuellement et par la suite assemblé et monté chacun dans une pièce d'horlogerie, par exemple dans un oscillateur ou dans un mécanisme d'échappement d'un mouvement horloger mécanique.

La présente invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation et leurs variantes, ceci ne signifie pas nécessairement que chaque référence concerne le même mode de réalisation ou variante, ou que les caractéristiques s'appliquent seulement à un seul mode de réalisation ou variante. De simples caractéristiques de différents modes de réalisation et leurs variantes peuvent également être combinées et/ou interchangées pour fournir d'autres réalisations.

## Revendications

1. Procédé de fabrication d'une pluralité de composants horlogers (90) en silicium dans une plaquette, le procédé comprenant les étapes suivantes :

   (a) se doter d'une plaquette (10, 110) ayant un côté inférieur (10A, 110A) et un côté supérieur (10B, 110B), la plaquette (10, 110) comprenant une couche simple en silicium (30, 130) sans couche de support, la couche simple (30, 130) ayant une épaisseur ($e_{30}$, $e_{130}$) plus importante qu'une épaisseur maximale ($e_{90}$) des composants horlogers ;
   (b) former les composants horlogers (90) en gravant des motifs dans la couche en silicium (30, 30', 130, 130') depuis le côté supérieur (10B, 110B) de la plaquette (10, 110) ; et
   (c) soit avant soit après l'étape (b), graver la plaquette (10, 110) depuis son côté inferieur (10A, 110A) pour amincir la plaquette au moins localement en formant au moins une zone amincie (36, 38, 38', 136) dans laquelle les composants horlogers (90) ont été ou seront formés, l'au moins une zone amincie (36, 38, 38', 136) ayant une épaisseur sensiblement égale à l'é-

paisseur maximale ($e_{90}$) des composants horlogers.

2. Procédé selon la revendication précédente, dans lequel l'étape (c) est réalisée après l'étape (b).

3. Procédé selon la revendication précédente, dans lequel les motifs gravés dans la couche en silicium (30) ne s'étendent pas sur toute l'épaisseur ($e_{30}$) de la couche simple (30).

4. Procédé selon la revendication précédente, dans lequel lesdits motifs sont séparés par des tranchées (35) ayant une profondeur (p) plus importante que l'épaisseur maximum ($e_{90}$) des composants horlogers (90).

5. Procédé selon l'une des revendications 2 à 4, dans lequel au moins une couche de protection (55) est formée sur au moins une partie des surfaces des composants horlogers (90) avant la réalisation de l'étape (c).

6. Procédé selon la revendication précédente, dans lequel l'au moins une couche de protection comprend une couche en oxyde de silicium (55).

7. Procédé selon la revendication 1, dans lequel l'étape (c) est réalisée avant l'étape (b).

8. Procédé selon la revendication précédente, dans lequel avant la réalisation de l'étape (b), une couche d'arrêt est formée sur une surface inferieure de la couche simple (130) depuis le côté inferieur (110A) de la plaquette (110), cette couche d'arrêt étant formée au moins sur une surface base de l'au moins une zone amincie (136) de la plaquette afin de faciliter la gravure qui forme les motifs des composants horlogers lors de l'étape (b).

9. Procédé selon l'une des revendications précédentes, dans lequel l'au moins une zone amincie (36, 38, 38', 136) de la plaquette a une superficie plus importante que la superficie d'un composant horloger sur la couche simple (30, 130) de la plaquette.

10. Procédé selon l'une des revendications précédentes, dans lequel plusieurs zones amincies (36, 136) sont gravées lors de l'étape (c), les zones amincies (36, 136) étant séparées par des régions (37, 137) qui ne sont pas amincies, et dans lequel au moins un des composants horlogers (90), et de préférence un seul des composants horlogers (90), est ou sera formé dans chaque zone amincie (36, 136).

11. Procédé selon l'une des revendications 1 à 9, dans lequel une seule zone amincie (38, 38') est gravée lors de l'étape (c), et dans lequel tous les composants horlogers (90) de la plaquette (10, 110) sont ou seront formés dans ladite zone amincie (38, 38').

12. Procédé selon l'une des revendications précédentes, dans lequel l'au moins une zone amincie (36, 38, 136) est entourée par une région périphérique (39) de la plaquette (10, 110) qui n'est pas amincie.

13. Procédé selon l'une des revendications 1 à 9 ou 11, dans lequel lors de l'étape (c), toute la superficie de couche simple (30, 130) est amincie afin qu'une seule zone amincie (38') s'étende sur la totalité de la couche simple (30, 130).

14. Procédé selon l'une des revendications précédentes, dans lequel la plaquette (10, 110) est gravée à l'étape (c) par une gravure humide.

15. Procédé selon la revendication précédente, dans lequel la gravure humide à l'étape (c) est une gravure humide anisotrope, de préférence une gravure humide utilisant un bain d'hydroxyde de potassium (KOH) ou d'hydroxyde de tétraméthylammonium (TMAH).

16. Procédé selon l'une des revendications précédentes, dans lequel la vitesse de gravure à l'étape (c) est ralentie, en variant les paramètres de la gravure, quand l'épaisseur de l'au moins une zone amincie (36, 38, 38', 136) s'approche de l'épaisseur maximale ($e_{90}$) des composants horlogers (90).

17. Procédé selon l'une des revendications précédentes dans lequel, après la formation des composants horlogers (90) à l'étape (b), les composants horlogers (90) sont supportés structurellement par des ponts de liaison (32, 132) qui les maintiennent attachés à des parties subsistantes de la couche en silicium.

FIG. 1a

FIG. 1b

FIG. 1c

FIG. 1d

FIG. 1e

FIG. 1f

FIG. 1g

FIG. 1h

FIG. 1i

FIG. 1j

FIG. 1k

FIG. 1l

FIG. 1m

FIG. 1n

10

37    36    37    55

55    30'

$e_{90}$

50    55    55

90'

FIG. 1o

10

37    56    36    37    55

$e_{30}$    55    30''

$e_{90}$

50    55    55

90

FIG. 1p

10

37    37

$e_{30}$    p2    36    30''

$e_{90}$

32

90

FIG. 1q

III

III

30''

90

**FIG. 2**

90

32

30''

**FIG. 2A**

FIG. 3A

FIG. 3B

FIG. 3C

110

110A

130

$e_{130}$

$e_{90}$

110B

FIG. 4a

110

155

130

150

FIG. 4b

110

165

155

130

150

FIG. 4c

165E

80

175

110

165

155

130

150

FIG. 4d

110

165

155

130

150

FIG. 4e

110

165

155

130

150

FIG. 4f

110

155

130

150

FIG. 4g

110

137        137        155

p2        136        130'

$e_{130}$

$e_{90}$

150

FIG. 4h

110

110B        150

$e_{90}$

137        136        137        130'

155

110A

FIG. 4i

110

160

150

$e_{90}$

137        136        137        130'

155

FIG. 4j

FIG. 4k

FIG. 4l

FIG. 4m

110

$e_{90}$

150

130'

137          136          137

155

**FIG. 4n**

90

110

135          135

150

$e_{90}$

130''

137          136          137

155

**FIG. 4o**

90

132

110

$e_{90}$

137          136          137

130''

**FIG. 4p**

Europäisches
Patentamt

European
Patent Office

Office européen
des brevets

## RAPPORT DE RECHERCHE EUROPEENNE

Numéro de la demande

EP 24 16 7072

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP 2016 173355 A (CITIZEN HOLDINGS CO LTD) 29 septembre 2016 (2016-09-29) * alinéas [0056] - [0067]; figure 9 * ----- | 1-6,9-17 | INV. G04B17/06 G04D3/00 B81C1/00 |
| X | JP 2017 219520 A (CITIZEN WATCH CO LTD) 14 décembre 2017 (2017-12-14) * alinéas [0118] - [0127]; figures 6A-6D,8A-8E * ----- | 1,7,8, 13-15 | |

DOMAINES TECHNIQUES
RECHERCHES (IPC)

G04B
G04D
B82B
B81C

Le présent rapport a été établi pour toutes les revendications

| Lieu de la recherche | Date d'achèvement de la recherche | Examinateur |
|---|---|---|
| La Haye | 9 septembre 2024 | Cavallin, Alberto |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

&.................................................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 24 16 7072

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-09-2024

| Document brevet cité au rapport de recherche | Date de publication | Membre(s) de la famille de brevet(s) | Date de publication |
|---|---|---|---|
| JP 2016173355 A | 29-09-2016 | JP 2016173355 A | 29-09-2016 |
| | | JP 2016173356 A | 29-09-2016 |
| JP 2017219520 A | 14-12-2017 | JP 6736365 B2 | 05-08-2020 |
| | | JP 2017219520 A | 14-12-2017 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- EP 3495894 A
- WO 2019180596 A
- JP 2017219520 B
- WO 2019180177 A

**Littérature non-brevet citée dans la description**

- **SEIDEL et al.** Anisotropic wet chemical structuring of silicon according. *J. Electrochem. Soc.*, November 1990, vol. 137 (11), 3612-3632
- **JUN et al.** Silicon etching characteristics for tetramethylammonium hydroxide-based solution with additives. *IET Micro & Nano Letters*, October 2015, vol. 10 (10), 487-490